Europäisches Patentamt

European Patent Office

Office européen des brevets

(19)

(11) **EP 0 963 623 B1**

(12) **FASCICULE DE BREVET EUROPEEN**

(45) Date de publication et mention
de la délivrance du brevet:
**25.07.2001 Bulletin 2001/30**

(21) Numéro de dépôt: **98912560.4**

(22) Date de dépôt: **27.02.1998**

(51) Int Cl.⁷: **H03C 7/02**, H04L 27/20

(86) Numéro de dépôt international:
**PCT/FR98/00384**

(87) Numéro de publication internationale:
**WO 98/38730 (03.09.1998 Gazette 1998/35)**

(54) **CIRCUIT ELECTRONIQUE MODULATEUR PAR DEPLACEMENT DE PHASE A STRUCTURE DISTRIBUEE**

ELEKTRONISCHE PHASENUMTASTUNG-MODULATORSCHALTUNG MIT VERTEILTER STRUKTUR

PHASE-SHIFT KEYING ELECTRONIC CIRCUIT WITH DISTRIBUTED STRUCTURE

(84) Etats contractants désignés:
**DE ES FI FR GB IT NL SE**

(30) Priorité: **28.02.1997 FR 9702589**

(43) Date de publication de la demande:
**15.12.1999 Bulletin 1999/50**

(73) Titulaire: **CENTRE NATIONAL D'ETUDES SPATIALES**
**F-75039 Paris Cedex 01 (FR)**

(72) Inventeurs:
 • **LAPIERRE, Luc**
  **F-31500 Toulouse (FR)**
 • **BOULANGER, Cyrille**
  **F-31400 Toulouse (FR)**
 • **ZANCHI, Christine**
  **F-31000 Toulouse (FR)**

(74) Mandataire:
**Cabinet BARRE LAFORGUE & associés**
**95, rue des Amidonniers**
**31000 Toulouse (FR)**

(56) Documents cités:
**US-A- 3 867 574        US-A- 5 442 327**
**US-A- 5 463 355**

 • **BOVEDA A ET AL: "A 0.7-3 GHZ GAAS QPSK/QAM DIRECT MODULATOR" IEEE JOURNAL OF SOLID-STATE CIRCUITS, vol. 28, no. 12, 1 décembre 1993, pages 1340-1349, XP000435908**
 • **A. PRIMEROSE ET AL.: "High Bit Rate Four Phase MMIC Remodulation Demodulator and Modulator" PROCEEDINGS OF THE GAAS92 EUROPEAN GALLIUM ARSENIDE AND RELATED III-V COMPOUNDS APPLICATIONS SYMPOSIUM, 27 - 29 avril 1992, NOORDWIJK, XP002046700 cité dans la demande**

**Description**

L'invention concerne un circuit modulateur par déplacement de phase (dit PSK "phase Shift keying" ou MDP "modulation de phase").

De tels circuits (voir par example US-A 3 867 574) sont utiles en particulier pour la transmission de signaux numériques. Par exemple, la transmission d'informations numériques entre un satellite et la Terre peut être effectuée par la modulation de phase d'un signal porteur hyperfréquence par un signal numérique.

On connaît déjà des circuits modulateurs à deux états de phase (dits BPSK OU MDP2), ou à quatre états de phase (dits QPSK ou MDP4) ("HIGH BIT RATE FOUR PHASE MMIC REMODULATION DEMODULATOR AND MODULATOR", A. Primerose et al., Proceedings of GAAS'92, Estec, Nordwich, Pays-Bas). Un BPSK peut être ainsi constitué d'un filtre passe-bas et d'un filtre passe-haut montés en parallèle et dont les sorties sont commutées sur une sortie commune par un montage de deux transistors MESFET en shunt dont les grilles reçoivent des signaux complémentaires à deux états. Ce circuit présente l'avantage de fournir un déphasage entre les signaux qui tend naturellement par construction vers la valeur théorique de 180°, malgré les imperfections de fabrication inévitables. En outre, les transistors MESFET utilisés en commutation ne sont pas polarisés et le circuit n'induit que de faibles pertes (de l'ordre de 3 dB). Il peut être réalisé en technologie MMIC et est de faible encombrement (typiquement 2 mm x 1 mm pour 8 GHz). Néanmoins, un tel BPSK présente l'inconvénient de présenter un encombrement spectral important pour un rythme de bits donné. En outre, il ne comporte aucun moyen de réglage de type électrique et n'autorise pas des déphasages avec d'autres valeurs que 180°, de sorte qu'il ne peut être utilisé dans certaines applications où l'on souhaite une porteuse résiduelle d'amplitude non nulle (par exemple pour synchroniser un récepteur).

Un circuit QPSK formé à partir de deux BPSK permet un encombrement spectral plus faible pour un même rythme de bits, mais présente encore les inconvénients de l'absence de moyen de réglage à partir d'une commande électrique et de n'autoriser que des déphasages de valeur fixe. En outre, ces circuits créent des pertes plus importantes (de l'ordre de 8 dB), et présentent un encombrement de l'ordre de 2,5 mm x 3,5 mm à 8 GHz.

On connaît aussi des circuits π/4-QPSK ("π/4-QPSK MODEMS FOR SATELLITE SOUND/DATA BROADCAST SYSTEMS", Chiu-Liang Liu, Kassilo Feher, IEEE Transactions on broadcasting, vol. 37, n° 1, March 1991, pp 1-8) qui sont des circuits à huit états de phase obtenus par déphasage supplémentaires de π/4 à chaque changement de phase. Ces circuits présentent les mêmes inconvénients que les QPSK traditionnels sus-mentionnés. Il est aussi à noter que sur les huit états de phase possibles, seules certaines transitions de phase sont autorisées, de sorte que les π/4-QPSK ne sont compatibles qu'avec un codage approprié, et en particulier ne peuvent être utilisés avec certains codages de signaux numériques à transmettre.

Le document "A VERSATILE VECTOR MODULATOR DESIGN FOR MMIC", L.M. Devlin, B.J. Minnis, 1990 IEEE MTT-S Digest L-7 pp 519-522, décrit un circuit modulateur à deux fois quatre états de phase, c'est-à-dire produisant deux constellations vectorielles d'amplitudes différentes. Ce circuit a un encombrement de 4mm x 3mm à 8 GHz, et présente quatre résistances variables dont l'ajustement est complexe. En outre, il est fonctionnellement équivalent à un QPSK, puisque les huit états de phase, n'ayant pas la même amplitude, ne sont pas utilisables pour une stricte modulation de phase (sans modulation d'amplitude) à huit états de phase.

Dans le but de réduire la puissance à l'émission, on cherche à utiliser un codage des signaux numériques performant tel que la MCT (modulation codée treillis). Pour ce faire, il est indispensable de disposer de circuits modulateurs ayant un nombre d'états de phase supérieur à quatre (notamment 8, 16...).

Or, il n'est pas envisageable de combiner l'architecture des BPSK ou QPSK connus sur un même circuit dans le but d'améliorer les performances en débit d'informations car les imperfections de chaque composant se répercutent les uns sur les autres et se cumulent sur la sortie. En outre, on obtient une perte de puissance rédhibitoire, notamment pour les systèmes embarqués sur les engins aéronautiques ou spatiaux. Par ailleurs, les mises au point à la fabrication, très coûteuses, devraient être multipliées.

L'invention vise donc à pallier ces inconvénients en proposant un circuit modulateur PSK dont la structure permet d'obtenir des états de phase de valeurs quelconques avec une perte de puissance nulle ou faible et avec une faible consommation d'énergie, de sorte que ce circuit peut être adapté et utilisé avec de nombreux types de codage et de modulation de phase et dans de nombreuses applications.

L'invention vise en outre à proposer un circuit modulateur dont le nombre d'états de phase peut être supérieur à quatre (avec une même amplitude et une même fréquence), notamment égal à huit, seize...

L'invention vise en outre à proposer un tel circuit modulateur PSK qui est avantageusement adapté à une réalisation en technologie monolithique micro-ondes (MMIC) -notamment sur arséniure de gallium GaAs-avec une excellente précision.

Plus particulièrement, l'invention vise à proposer un circuit modulateur PSK présentant un moyen de réglage simple des états de phase, notamment en fonction de la fréquence du signal d'entrée, de façon à permettre l'ajustement de ses caractéristiques en fonction du système dans lequel il est incorporé, et ce au moment même de son incorporation dans le système (et non lors de la conception ou de la fabrication du circuit intégré PSK lui-même).

L'invention vise en outre plus particulièrement à proposer un tel circuit modulateur PSK compatible avec les contraintes des systèmes spatiaux embarqués (faible encombrement, excellente fiabilité, faible consommation...)

L'invention vise aussi plus particulièrement à proposer un tel circuit modulateur PSK compatible avec les codages de modulation à haut débit tels que la MCT.

L'invention vise aussi plus particulièrement à proposer un tel circuit modulateur PSK pouvant être adapté à toute fréquence de signaux porteurs, notamment dans le domaine des hyperfréquences.

L'invention vise aussi plus particulièrement à proposer un tel circuit modulateur PSK qui, une fois réalisé, peut accepter des signaux porteurs en entrée dont la fréquence est fixe, mais peut être choisie dans une large bande (par exemple dans la bande X ou la bande Ka pour des télémesures d'observation de la terre, dans la bande K des satellites de télécommunication multimédia...).

L'invention vise en outre à proposer un tel circuit modulateur PSK qui ne produise pas de perturbations sensibles de la ligne et du signal d'entrée.

Pour ce faire, l'invention concerne un circuit électronique modulateur par déplacement de phase comprenant une entrée destinée à recevoir un signal d'entrée sinusoïdal Se de pulsation $\omega e$ et une sortie délivrant un signal sinusoïdal Ss déphasé du signal d'entrée d'une valeur $\phi j$ qui peut varier parmi m valeurs, $\phi 1, ..., \phi j, ..., \phi m$, m étant un entier supérieur ou égal à 2, en fonction d'un signal de commande SCj, le signal de sortie ayant une pulsation $\omega s$ indépendante du signal de commande SCj, caractérisé en ce qu'il comprend :

- une ligne de distribution s'étendant à partir de l'entrée et comprenant n cellules Co, ..., Ci, ..., Cn-1, de déphasage semblables, n étant un nombre entier supérieur ou égal à 2, les n cellules de déphasage étant montées le long de la ligne de distribution avec chaque cellule Ci de déphasage de rang i le long de la ligne de distribution comprenant :

  . une entrée, dite entrée série ISi, recevant le signal provenant de l'entrée du circuit, soit directement pour i = 0, soit par l'intermédiaire des (i-1) cellules de déphasage précédentes de rang inférieur à i, interposées entre l'entrée du circuit et cette cellule Ci de déphasage,
  . une première sortie, dite sortie série OSi, délivrant le signal sur la ligne de distribution à une cellule Ci+1 de déphasage subséquente de rang i+1 supérieur, ou, pour i = n-1, à un dispositif de terminaison de la ligne de distribution,
  . un noeud Ni de dérivation de la ligne de distribution,
  . une deuxième sortie, dite sortie dérivée ODi, reliée au noeud Ni de dérivation par l'intermédiaire d'un transistor Ti dont une première borne est reliée au noeud Ni de dérivation, dont une deuxième borne est reliée à la masse, et dont la troisième borne fournit ladite sortie dérivée ODi de la cellule Ci de déphasage, chaque cellule Ci de déphasage étant adaptée pour délivrer sur sa sortie dérivée ODi un signal SDi déphasé, par rapport au signal d'entrée Se, de la somme $\phi(Ci)$ des déphasages apportés au signal d'entrée Se successivement, depuis l'entrée du circuit, par les cellules de déphasage interposées entre l'entrée du circuit et ladite sortie dérivée ODi,

- relié à ladite sortie dérivée ODi de chaque cellule Ci de déphasage, un circuit commutateur/modulateur commandé à partir du signal de commande SCj, ce circuit commutateur/modulateur étant :

  . lorsque n = m, un circuit commutateur délivrant soit un signal nul, soit le signal SDi reçu de la cellule Ci, en fonction du signal de commande SCj,
  . lorsque n ≠ m, un circuit modulateur de phase à p états, p étant un nombre entier inférieur à m choisi de façon que $m \leq p^n$, adapté pour déphaser le signal SDi reçu de la cellule Ci de déphasage d'une valeur $\phi k$, k étant un nombre entier variant entre 1 et p en fonction du signal de commande SCj,

- des moyens pour sommer en phase les signaux Ssi issus des n circuits commutateurs/modulateurs, et pour délivrer sur ladite sortie du circuit le résultat de cette somme qui forme le signal de sortie Ss.

Ainsi, un circuit selon l'invention présente une structure de type distribuée. Cette structure procure de grandes possibilités d'adaptation. En particulier, on peut optimiser le nombre n des cellules de déphasage en fonction du nombre m d'états de phase souhaité. On peut aussi optimiser le déphasage appliqué sur le signal par chaque cellule de déphasage et, le cas échéant, par chaque circuit modulateur à p états de phase.

Dans toute la présente demande, l'expression "cellules de déphasage semblables" signifie que les cellules sont constituées avec des composants électroniques présentant les mêmes fonctions électroniques, même si la structure et les valeurs de ces composants peuvent être différentes d'une cellule à l'autre. En outre, l'expression "cellules de déphasage fonctionnellement identiques" désigne des cellules de déphasage qui sont semblables et qui sont conçues pour induire normalement toutes le même déphasage sur le signal entre leur entrée et leurs sorties.

Il est à noter que les circuits modulateurs à p états de phase utilisés en sortie des cellules de déphasage peuvent eux-mêmes présenter une structure distribuée selon l'invention. De la sorte, l'invention permet la réalisation de circuits modulateurs "multi-étages" comprenant plusieurs étages de déphasage PSK imbriqués en cascade.

En pratique, on constate que cette structure distribuée permet effectivement d'obtenir une précision suffisante de chaque état de phase pour réaliser -notamment en technologie MMIC- un circuit à huit états de phase, voire même plus.

Avantageusement et selon l'invention, le circuit comporte des moyens de polarisation des transistors des cellules de déphasage. Ainsi, chaque étage de déphasage PSK est amplifié par ces transistors qui apportent un gain au signal.

En outre, avantageusement et selon l'invention, chacun desdits transistors est un transistor à effet de champ -notamment MESFET (sur GaAs)- dont :

- la première borne est la grille,
- la deuxième borne est la source,
- la troisième borne est le drain.

Les transistors à effet de champ présentent une conductance d'entrée dont la partie réelle est très faible, ce qui charge peu la ligne de distribution, et permet donc d'obtenir un niveau quasi-identique sur chacun des noeuds de dérivation et sur chaque sortie dérivée. Tous les circuits commutateurs/modulateurs situés en aval sont donc alimentés avec le même niveau de signal.

En outre, les circuits commutateurs/modulateurs de chaque branche dérivée sont isolés les uns des autres par les transistors à effet de champ et ne se perturbent pas mutuellement (par exemple, si chaque circuit commutateur/modulateur est un BPSK, les variations des TOS (taux d'ondes stationnaires) des BPSK au rythme des changements d'états ne risquent pas de dégrader la précision des états).

De même, les transistors à effet de champ isolent la ligne et le signal d'entrée, qui n'est pas perturbé par les commutations induites par le circuit.

En outre, un circuit selon l'invention comprend des moyens pour appliquer une tension continue de valeur ajustable à chaque noeud Ni de dérivation, de façon à former une capacité ajustable entre le noeud Ni de dérivation et la masse. En effet, les transistors à effet de champ présentent une capacité d'entrée non linéaire ajustable par la tension de polarisation de la grille. Cette capacité variable, en parallèle sur la ligne de distribution, permet d'ajuster le déphasage généré par chaque cellule. Cela permet d'améliorer la précision des états de phase et de minimiser les risques de mauvais fonctionnement liés à réalisation du circuit en fonderie.

Avantageusement, un circuit selon l'invention est caractérisé en ce que chaque cellule Ci de déphasage est du type à inductance série et capacité parallèle, en ce que ledit transistor de chaque cellule Ci de déphasage est un transistor à effet de champ polarisé, dont la grille est reliée au noeud de dérivation Ni à la ligne de distribution en parallèle à l'inductance, dont la source est reliée à la masse, et dont le drain fournit le signal dérivé SDi à ladite sortie dérivée, et en ce que ladite capacité parallèle est au moins pour partie constituée de la capacité formée entre la grille et la source dudit transistor à effet de champ polarisé.

En outre, avantageusement et selon l'invention, toutes les cellules de déphasage sont fonctionnellement identiques et créent un même déphasage $\Delta\phi$ le long de la ligne de distribution, la cellule Ci délivrant sur sa sortie dérivée un signal dérivé SDi déphasé, par rapport au signal d'entrée Se, de $\phi(Ci) = ix\Delta\phi+\psi$, où $\psi$ est une constante. Ce déphasage $\Delta\phi$ identique pour toutes les cellules peut être égal à $2\pi/m$, ou différent de $2\pi/m$ (si l'on souhaite un signal de sortie de valeur moyenne non nulle).

En outre, avantageusement et selon l'invention, les moyens pour appliquer et ajuster une tension continue de valeur ajustable à chaque noeud Ni de dérivation comportent une borne de la ligne de distribution adaptée pour pouvoir recevoir une tension continue, de sorte que les déphasages du signal à chaque noeud Ni de dérivation des cellules Ci de déphasage peuvent être ajustés simultanément, notamment en fonction de la pulsation $\omega e$, par réglage de cette seule tension continue variable. Il est à noter que la technologie MMIC est particulièrement bien adaptée à ce réglage simultané de toutes les cellules de déphasage LC car les transistors d'une même puce présentent très peu de dispersion, de sorte que les capacités d'entrée des transistors sont égales et varient de la même manière avec la polarisation.

Avantageusement et selon l'invention, lesdits moyens pour sommer en phase comprennent, notamment lorsque n = m, des lignes de branchement en étoile des sorties des n circuits commutateurs modulateurs en un noeud de sortie commun et ces lignes de branchement sont toutes de la même longueur, de façon à présenter une impédance de sortie constante, en général de 50 Ohms.

En outre, avantageusement et selon l'invention, et notamment lorsque n $\neq$ m, lesdits moyens pour sommer en phase comprennent un circuit combineur en phase formé d'une arborescence de coupleurs de Wilkinson dont le dernier sommet forme ladite sortie du circuit. L'avantage des coupleurs de Wilkinson est d'isoler lesdits circuits modulateurs de phase à p états les uns des autres du côté de la sortie. Ainsi, ces circuits sont isolés du côté de l'entrée par les transistors des cellules de déphasage et du côté de la sortie par les coupleurs de Wilkinson.

Avantageusement et selon l'invention, lorsque m est un multiple d'une puissance de 2, on choisit n égal à une puissance de 2. De la sorte, l'arborescence des coupleurs de Wilkinson présente une symétrie axiale par rapport à la sortie du circuit (puisque chaque coupleur de Wilkinson comprend deux entrées et une sortie).

Avantageusement, un circuit selon l'invention est caractérisé en ce que :

- m est supérieur ou égal à 4,
- p est égal à 1, 2 ou 4.

Avantageusement, un circuit selon l'invention est caractérisé en ce que :

- m est supérieur ou égal à 8,
- n est supérieur ou égal à 4.

Plus généralement, n est avantageusement supérieur ou égal à m/2. Ainsi, le nombre d'états de phase des circuits modulateurs en sortie des cellules de déphasage peut être minimisé (notamment égal à 2).

Par ailleurs, avantageusement et selon l'invention, les circuits commutateurs/modulateurs sont semblables et comprennent uniquement des composants passifs. Dans toute la présente demande, on désigne par "composants passifs" tous composants montés de façon à ne nécessiter aucune alimentation accessoire en énergie électrique pour leur fonctionnement (résistances, inductances, capacités, transistors non polarisés...).

Avantageusement, et notamment lorsque m est un multiple de 2, un circuit selon l'invention est caractérisé en ce que p = 2 et en ce que les circuits commutateurs/modulateurs sont des circuits BPSK de modulation de phase à deux états de phase à composants passifs formés chacun d'un filtre passe-haut et d'un filtre passe-bas montés en parallèle et dont les sorties sont commutées par un montage à transistors à effet de champ non polarisés avec leur grille recevant un signal de commande à deux états complémentaires. Ainsi, les circuits modulateurs de phase à p états de phase sont des BPSK traditionnels (p = 2).

En outre, avantageusement, un circuit selon l'invention comporte des moyens formant une impédance variable à une borne d'extrémité de la ligne de distribution opposée à l'entrée du circuit, pour permettre son adaptation d'impédance.

Avantageusement et selon l'invention, l'impédance variable comprend un transistor à effet de champ monté en résistance variable, et dont la grille reçoit une tension continue de réglage.

Avantageusement et selon l'invention, un circuit selon l'invention est caractérisé en ce que la fréquence du signal d'entrée étant supérieure à 1 Gigahertz, il est formé d'un circuit intégré monolithique.

L'invention s'étend aussi à un circuit caractérisé en ce qu'il comprend en combinaison tout ou partie des caractéristiques ci-dessus ou ci-après mentionnées.

D'autres buts, caractéristiques et avantages de l'invention apparaîtront dans la description suivante d'exemples non limitatifs de réalisation de l'invention et qui se réfère aux figures annexées dans lesquelles :

- la figure 1 est une vue schématique d'ensemble d'un circuit selon l'invention,
- la figure 2 est une vue schématique d'un mode de réalisation d'un circuit selon l'invention avec m = 8, n = 4, p = 2,
- la figure 3 est une vue schématique d'un mode de réalisation de circuit modulateur à deux états de phase BPSK du circuit de la figure 2,
- les figures 4 et 5 sont des diagrammes de Fresnel illustrant deux exemples de la construction vectorielle dans le plan complexe du signal de sortie du circuit de la figure 2,
- la figure 6 est un diagramme de Fresnel illustrant dans le plan complexe une constellation à 8 états de phase du signal de sortie pouvant être obtenue avec le circuit de la figure 2,
- la figure 7 est une vue schématique d'un mode de réalisation d'un circuit selon l'invention avec m = n = 2 et p = 1.

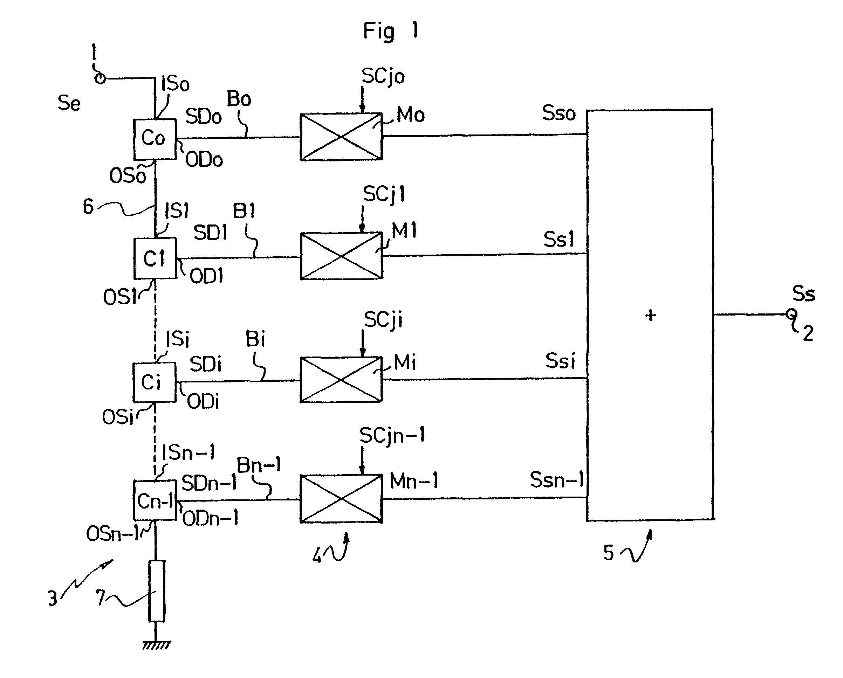

Un circuit selon l'invention représenté de façon générale figure 1 comprend une entrée 1 destinée à recevoir, sous forme d'un courant électrique, un signal d'entrée $S_e = A\sin(\omega_e t + \phi_e)$ et une sortie 2 destinée à délivrer, sous forme d'un courant électrique, un signal de sortie $S_s = A'\sin(\omega_s t + \phi_s)$ modulé en phase en fonction d'un signal de commande $SC_j$ qui est généralement un signal numérique ou représente un signal numérique.

Le circuit selon l'invention est un circuit modulateur à déplacement de phase (du type dit PSK ou MDP), à m états de phase, c'est-à-dire que le signal de sortie $S_s$ est déphasé du signal d'entrée d'une valeur $\phi_j = \phi_s - \phi_e$ qui peut varier parmi m valeur $\phi_1$, $\phi_2$, ..., $\phi_j$, ..., $\phi_m$, m étant un nombre entier supérieur ou égal à 2.

Par contre, la pulsation $\phi\omega_s$ du signal de sortie est indépendante du signal de commande $SC_j$, et en général est identique à $\omega_e$. Le circuit selon l'invention est particulièrement adapté au traitement de signaux dans le domaine des hyperfréquences (classiquement de 1 GHz à 300 GHz) où les phénomènes de propagation sont importants. Néanmoins, l'invention est aussi applicable pour la réalisation de circuits modulateurs de phase dans toutes les gammes de fréquence.

Dans les modes de réalisation représentés, de préférence et selon l'invention, l'amplitude A' du signal de sortie peut varier en fonction du signal de commande $SC_j$, mais n'est en général pas utilisée comme paramètre de modulation. Néanmoins, le circuit selon l'invention est aussi compatible avec une modulation en amplitude combinée avec la modulation de phase, soit grâce à un codage de modulation qui exploite les différents états d'amplitude pouvant être obtenus par le circuit selon l'invention dans certaines configurations, soit par utilisation de moyens complémentaires de modulation d'amplitude disposés à l'amont et/ou à l'aval du circuit selon l'invention.

Le circuit selon l'invention comprend de l'amont vers l'aval, (c'est-à-dire depuis l'entrée 1 et jusqu'à la sortie 2) essentiellement trois étages successifs à savoir : un étage 3 de distribution/modulation primaire comprenant une ligne de distribution 6, au moins un étage 4 de commutation/modulation secondaire, et un étage 5 de multiplexage sur la sortie 2.

La ligne de distribution 6 permet de distribuer le signal sur une pluralité de n branches dérivées B0, B2, ..., Bi, ..., Bn-1, en lui appliquant un déphasage primaire $\phi(Ci)$ dépendant du rang i de la branche dérivée Bi. La ligne de distribution 6 comprend ainsi n cellules C0, C1, ..., Ci, ..., Cn-1 de déphasage semblables montées bout à bout en échelle pour définir les n branches dérivées. Le nombre n est un nombre entier supérieur ou égal à 2 (la ligne de distribution 6 comprenant au moins deux cellules de déphasage pour distribuer le signal sur au moins deux branches dérivées) et de préférence inférieur ou égal à m.

Chaque cellule Ci de déphasage de rang i de la ligne de distribution 6 comprend :

- une entrée, dite entrée série ISi recevant le signal provenant de l'entrée 1 du circuit, soit directement pour i=0, soit, pour i≠0, par l'intermédiaire des i-1 cellules de déphasage précédentes de rang inférieur interposées entre l'entrée 1 du circuit et cette cellule Ci de déphasage,
- une première sortie, dite sortie série OSi, reliée, pour i≠n-1, à l'entrée série ISi+1 d'une cellule Ci+1 de déphasage subséquente de rang i+1 supérieur ou, pour i=n-1, à un dispositif 7 de terminaison de la ligne de distribution 6, ladite sortie série OSi délivrant un signal, dit signal série SSi,
- une deuxième sortie, dite sortie dérivée ODi, reliée à l'une des branches dérivées Bi correspondant à ladite cellule Ci de déphasage, ladite sortie dérivée ODi délivrant un signal, dit signal dérivé SDi.

Chaque cellule Ci de déphasage est adaptée pour apporter un déphasage, dit déphasage série $\phi Si$ entre le signal qu'elle reçoit à son entrée série ISi (qui est le signal série SSi-1 délivré par la cellule Ci-1 immédiatement en amont sur la ligne) et celui SSi qu'elle délivre sur sa sortie série OSi, et pour apporter un déphasage, dit déphasage dérivé $\phi Di$, entre le signal qu'elle reçoit à son entrée série ISi et celui SDi qu'elle délivre sur sa sortie dérivée ODi.

Ainsi, le déphasage du signal série SSi par rapport au signal d'entrée Se est égal à

$$\sum_{t=0}^{i} \phi St$$

Le déphasage $\phi(Ci)$ présenté par le signal dérivé SDi appliqué sur la branche dérivée Bi par la cellule Ci par rapport au signal d'entrée Se s'écrit :

$$\phi(Ci) = \phi Di + \sum_{t=0}^{i-1} \phi St$$

Chaque cellule Ci de déphasage est avantageusement formée d'un filtre passe-bas LC à inductance série et capacité parallèle, et comprend un noeud de dérivation Ni auquel le signal présente, par rapport au signal de l'entrée série ISi, un déphasage qui dépend de la valeur de l'inductance série interposée entre l'entrée série ISi et le noeud de dérivation Ni et de la capacité parallèle totale formée entre le noeud de dérivation Ni et la masse.

Les cellules Ci de déphasage forment, entre l'entrée 1 et le dispositif 7 de terminaison, un montage de la ligne de distribution 6 qui peut être considéré comme un montage en L ou en T ou en π selon les branchements (avec ou sans inductance série) du premier noeud de dérivation No par rapport à l'entrée 1 et du dernier noeud de dérivation Nn-1 par rapport au dispositif 7 de terminaison de la ligne de distribution 6.

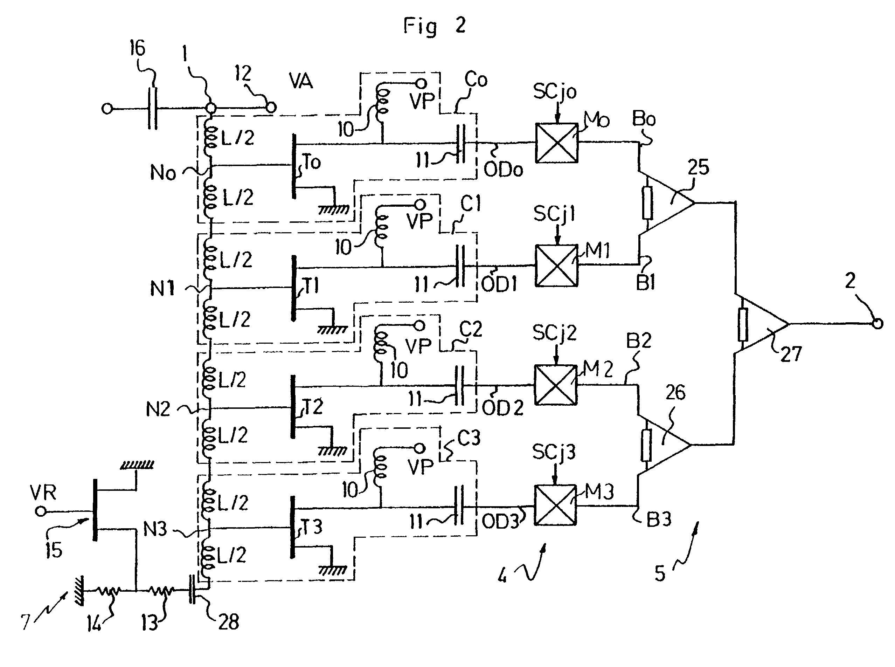

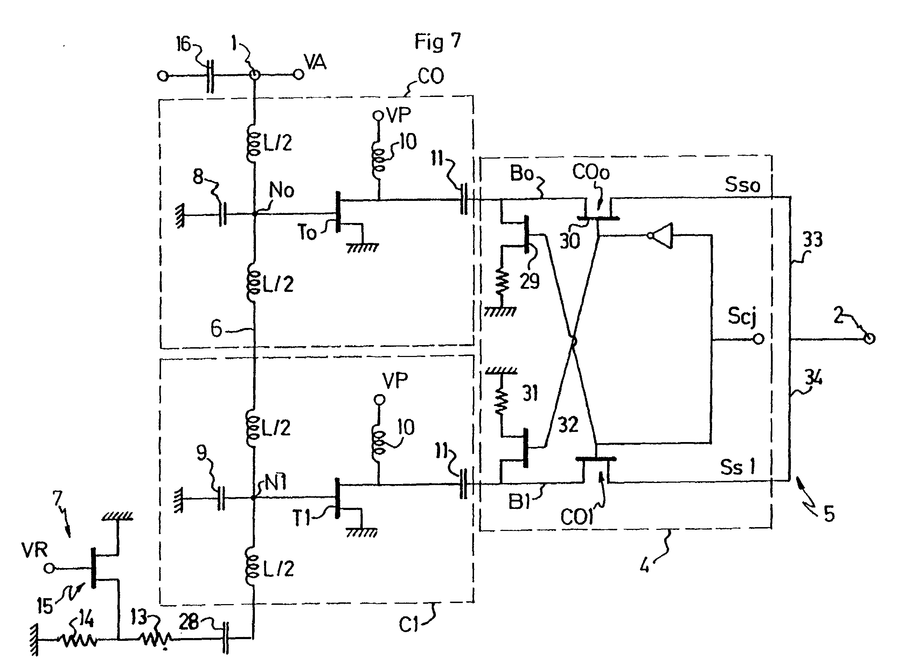

La figure 2 représente un montage pouvant être considéré comme un montage en T. Le noeud de dérivation Ni est relié à la sortie dérivée ODi de la cellule Ci par l'intermédiaire d'un transistor à effet de champ To, ..., Ti, ..., Tn-1, dont la grille est reliée directement au noeud de dérivation Ni, dont la source est reliée directement à la masse, et dont le drain est relié à la sortie dérivée ODi. Chaque transistor Ti est polarisé, de sorte que ladite capacité parallèle de la cellule Ci de déphasage est au moins pour partie constituée de la capacité formée entre la grille et la source du transistor Ti. Dans le mode de réalisation de la figure 2, la capacité parallèle de chaque cellule Ci de déphasage est constituée uniquement par le transistor Ti. Dans le mode de réalisation de la figure 7, un condensateur auxiliaire 8, 9 est interposé entre chaque noeud de dérivation et la masse.

Chaque cellule Ci de déphasage comprend des moyens 10, 11 de polarisation de son transistor Ti, par exemple sous la forme d'une inductance 10 de choc dont une borne est reliée au drain du transistor Ti et dont l'autre borne reçoit une tension continue VP fixe de polarisation, et d'un condensateur de blocage 11 monté en série entre le drain et la sortie dérivée ODi.

Avec un tel montage, la valeur de la capacité formée entre la grille et la source est non linéaire et dépend de la tension continue de polarisation de la grille. Le circuit selon l'invention comprend ainsi des moyens 12 pour appliquer une tension continue de valeur ajustable, après la fabrication du circuit, à chaque noeud de dérivation Ni. Ces moyens 12 peuvent simplement comprendre une borne 12 de la ligne de distribution 6 adaptée pour pouvoir recevoir une tension continue VA ajustable formée par des moyens de génération de tension externes au circuit. Un condensateur d'isolement 16 est prévu à l'amont de l'entrée 1 pour isoler la source générant le signal d'entrée (en général un oscillateur) de la tension continue VA.

Il est à noter qu'en variante ou en combinaison on peut utiliser les tensions de polarisation VP pour ajuster la valeur des déphasages créés par les cellules Ci de déphasage.

Dans le mode de réalisation de la figure 2, avantageusement et selon l'invention, la ligne de distribution 6 comprend une pluralité d'inductances disposées en série depuis l'entrée 1 du circuit jusqu'au dispositif 7 de terminaison, et séparées les unes des autres par les noeuds de dérivation No, ..., Ni, ..., Nn-1 auxquels les grilles des transistors Ti sont reliées. L'inductance L entre deux noeuds de dérivation est représentée séparée en deux parties L/2 pour figurer chacune des parties de cette inductance appartenant fonctionnellement respectivement à chaque cellule de déphasage correspondante (représentée en traits pointillés) et le montage en T ainsi réalisé.

Avantageusement et selon l'invention, toutes les cellules de déphasage Co à Cn-1 sont fonctionnellement identiques et créent un même déphasage série $\phi$Si et un même déphasage $\phi$Di à partir de leur entrée série ISi le long de la ligne de distribution 6.

Ainsi, pour tous les rangs i compris entre 1 et n-1, la différence de phase $\phi(Ci)-\phi(Ci-1) = \Delta\phi$ entre les signaux dérivés SDi et SDi-1 délivrés par les cellules Ci et Ci-1 qui se jouxtent sur la ligne de distribution, est la même le long de la ligne de distribution 6.

Avantageusement et selon l'invention, $\Delta\phi= 2\pi/m$. Autrement dit, $\phi(Ci)=ix\Delta\phi+\psi =2\pi i/m+\psi$ où $\psi$ est une constante. De la sorte, le signal Ss en sortie du circuit aura une amplitude moyenne (par rapport au temps) nulle (le circuit fournissant une modulation sans porteuse résiduelle).

Il est facile, par un choix approprié, lors de la conception du circuit, de la valeur de L et des transistors, d'obtenir les valeurs appropriées pour les déphasages primaires apportés au signal d'entrée par les cellules Ci de déphasage. Ces déphasages peuvent être en outre ajustés simultanément après la fabrication du circuit en appliquant une tension VA appropriée permettant de faire varier la capacité grille-source des transistors.

Il est à noter que cette structure est particulièrement appropriée à une réalisation en technologie monolithique -notamment MMIC- tous les transistors Ti étant identiques, présentant peu de dispersion et des capacités égales et variant de la même manière avec VA.

Le dispositif 7 de terminaison comprend un condensateur 28 d'isolement, deux résistances série 13, 14 et un transistor 15 à effet de champ monté en résistance variable dont le drain est relié en étoile entre les deux résistances série 13, 14, dont la source est à la masse et dont la grille reçoit une tension continue de réglage VR. On forme ainsi une résistance variable pouvant être ajustée à partir du paramètre électrique VR, ce qui permet d'adapter aisément l'impédance de la ligne de distribution 6, notamment pour tenir compte des variations apportées à la tension VA et aux capacités parallèles formées par les transistors Ti des cellules Ci de déphasage, et des variations technologiques des résistances 13, 14 à la fabrication.

Il est à noter que la ligne de distribution 6, et notamment les cellules Ci de déphasage, peuvent être réalisées autrement que par un montage de circuits LC en échelle, (par exemple lignes à retard, montages en T ponté .....), dès lors que chaque cellule Ci de déphasage délivre un signal dérivé SDi déphasé d'une valeur $\phi$(Ci) qui lui est propre par rapport au signal d'entrée Se.

L'étage 4 de commutation/modulation secondaire permet, en fonction d'un signal de commande SCj, de former des signaux de sortie de branche Ssi et à partir des n signaux dérivés SDi délivrés par les cellules Ci de déphasage sur leur sortie dérivée ODi.

Cet étage 4 de commutation/modulation secondaire comprend ainsi un circuit commutateur/modulateur Mi relié à la sortie dérivée ODi de chaque cellule Ci de déphasage sur chaque branche dérivée Bi, soit au total n circuits commutateurs/modulateurs Mo, ..., Mi, ..., Mn-1.

L'étage 4 peut être constitué, notamment si n = m, de simples circuits commutateurs en phase, délivrant en sortie un signal SSi qui est, soit chaque signal dérivé SDi, soit un signal nul selon l'état ou la valeur du signal de commande SCj.

Notamment si n ≠ m, l'étage 4 comprend des circuits modulateurs Mi de phase à p états de phase, p étant un nombre entier choisi de façon que m≤pn et p<m. Ces circuits sont donc eux-mêmes des PSK, mais ayant un nombre p d'états de phase choisi beaucoup moins important que le circuit selon l'invention. Chaque circuit modulateur Mi de phase est adapté pour déphaser le signal dérivé SDi qu'il reçoit d'une valeur $\phi$k, k étant un nombre entier variant entre 1 et p en fonction du signal de commande SCj.

En pratique et en général, on cherche à minimiser p pour simplifier la réalisation et mettre en oeuvre des circuits fiables et de faible consommation et pertes. Avantageusement, on choisit (de préférence si m est un multiple de 2, ce qui est le cas le plus courant) p = 2 et les circuits modulateurs Mi sont des BPSK.

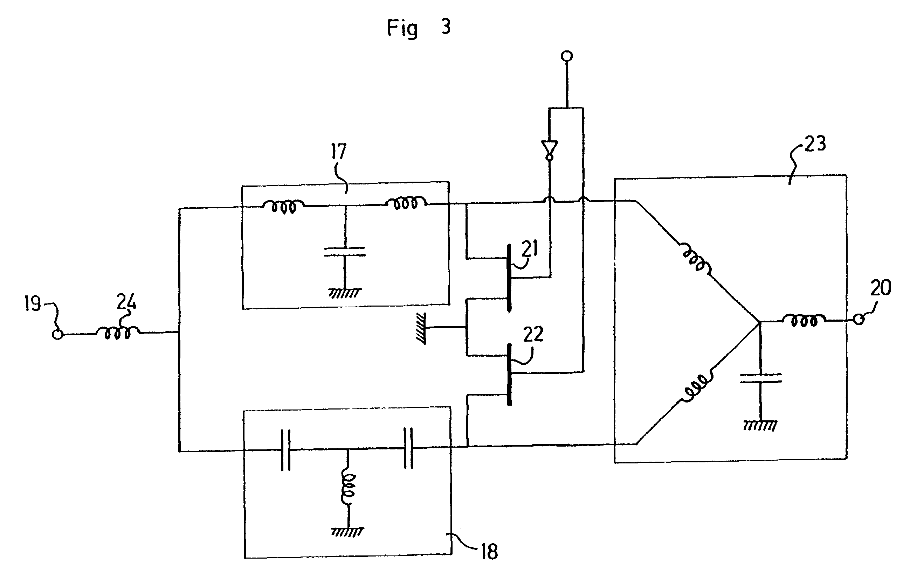

Tel est le cas du mode de réalisation de la figure 2 où n = 4 et p = 2, les circuits de modulation M0, M1, M2, M3 étant des BPSK réalisés de façon traditionnelle selon le schéma représenté figure 3. Chaque circuit M0 à M3 est formé d'un filtre LC passe-bas en T 17 et d'un filtre LC passe-haut en T 18, montés en parallèle à partir d'une borne d'entrée 19 et dont les sorties sont commutées et combinées en phase sur une borne de sortie 20 commune par un montage parallèle de deux transistors 21, 22 à effet de champ non polarisés de commutation ayant une borne reliée à la sortie du filtre correspondant 17, 18, une borne à la masse, et recevant par leur grille un signal de commande à deux états complémentaires de sorte qu'un seul des deux transistors 21, 22 est passant à la fois et que le transistor 21, 22 passant pour le premier état du signal de commande est bloqué pour le deuxième état. Les signaux issus des filtres et ainsi commutés sont combinés en phase par un combineur 23 à inductances en étoile et capacité parallèle d'adaptation sur la borne de sortie 20. Une inductance série d'adaptation 24 est prévue entre la borne d'entrée 19 et les filtres 17, 18. Un tel BPSK est connu en lui-même et présente notamment l'avantage d'un déphasage qui tend naturellement vers 180°, et d'être réalisable sur un circuit intégré MMIC.

En variante, on peut bien sûr utiliser un BPSK qui est lui-même conforme à la présente invention (par exemple selon un schéma semblable à celui de la figure 7) dans le circuit de la figure 2.

Le signal de commande SCj comprend n composantes à p états et est donc représentatif d'un signal numérique pouvant prendre $p^n$ valeurs. Néanmoins, les signaux Ssi issus des n circuits commutateurs/modulateurs Mi sont combinés en phase sur la sortie 2 grâce à l'étage 5 de multiplexage. Dès lors, le signal de sortie Ss ne représente parfois qu'un nombre $m < p^n$ états de phase (pour certaines valeurs de n, de p et des $\phi(Ci)$ les signaux peuvent s'annuler et/ou les états de phase peuvent se répéter).

Un signal de commande SCji est appliqué à chaque circuit commutateur/modulateur Mi, et ce signal SCji est l'une des composantes SCji du signal de commande SCj.

Les circuits modulateurs Mi délivrent chacun un signal de sortie de branche Ssi dont la phase est donc $\phi i = \phi(Ci) + \phi k$.

$\phi k$ varie avec le signal de commande SCj, et plus précisément avec la composante SCji du signal de commande qui est appliquée au circuit modulateur Mi. De préférence, tous les circuits modulateurs Mi sont identiques et adaptés pour que $\phi k = 2\pi k/p$.

Dans le mode de réalisation de la figure 2, le signal de commande SCji est formé de quatre composantes SCj0, SCj1, SCj2, SCj3 qui sont des tensions représentatives de niveaux logiques, pouvant prendre chacune deux valeurs complémentaires U0, $\overline{U0}$ ; U1, $\overline{U1}$ ; U2, $\overline{U2}$ ; U3, $\overline{U3}$.

Les signaux de sortie de branche Ss0, Ss1, Ss2, Ss3 peuvent être représentés dans le plan complexe par des vecteurs I, U, Q, V, et peuvent prendre chacun deux valeurs déphasées de 180°, et correspondant respectivement aux vecteurs I, -I ; U, -U ; Q, -Q ; V, -V.

L'étage 5 de multiplexage est constitué de moyens pour sommer en phase (somme vectorielle) les signaux Ssi et pour délivrer sur la sortie 2 du circuit le résultat de cette somme vectorielle, qui forme le signal de sortie Ss. Ces moyens comprennent un circuit combineur en phase formé d'une arborescence de coupleurs de Wilkinson (coupleurs de puissance en phase), dont le dernier sommet forme ladite sortie 2 du circuit.

Dans le cas de la figure 2 où n = 4, l'étage 5 de multiplexage comprend trois coupleurs de Wilkinson 25, 26, 27, à savoir deux coupleurs 25, 26 d'une première série couplant les signaux Ssi deux à deux et un coupleur 27 de deuxième série recevant les signaux issus des coupleurs 25, 26 de première série et délivrant le signal de sortie Ss sur la sortie 2.

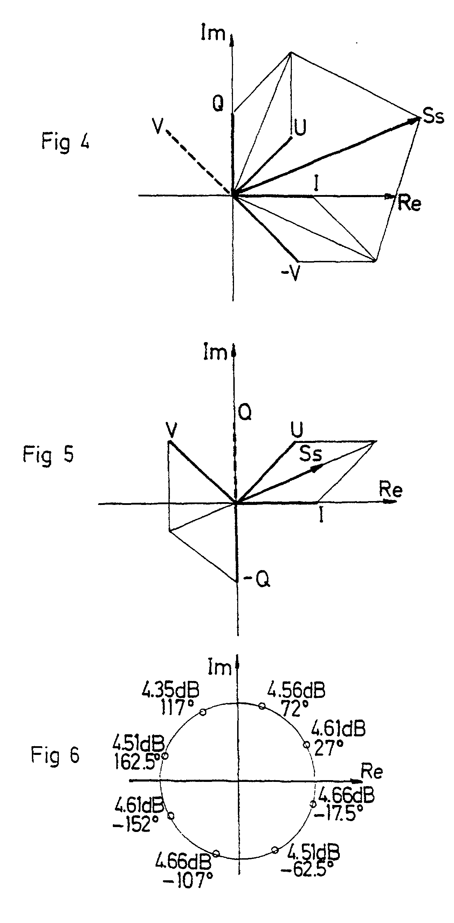

Si on choisit les inductances L et les transistors T0, T1, T2, T3 à effet de champ et VA pour que $\Delta\phi = \pi/4$, le signal de sortie Ss est représenté dans le plan complexe par un vecteur Ss qui décrit une double constellation à 8 états de phase. La première constellation correspond à des signaux Ss d'amplitude plus importante que ceux de la deuxième constellation. La figure 4 représente un exemple de construction d'un signal de sortie Ss correspondant à la première constellation, obtenue lorsque tous les signaux de sortie de branche Ssi sont déphasés deux à deux de $\pi/4$, c'est-à-dire lorsque le signal de commande SCj prend les valeurs suivantes :

|     | SCj0 | SCj1 | SCj2 | SCj3 |
| --- | --- | --- | --- | --- |
| SC1 | I | U | Q | -V |
| SC2 | I | U | Q | V |
| SC3 | -I | U | Q | V |
| SC4 | -I | -U | Q | V |
| SC5 | -I | -U | -Q | V |
| SC6 | -I | -U | -Q | -V |
| SC7 | I | -U | -Q | -V |
| SC8 | I | U | -Q | -V |

En théorie, avec cette première constellation, A'/A = 2,613.

La deuxième constellation, dont un exemple de construction du signal Ss est représenté figure 5, correspond aux cas où au moins une paire de signaux de sortie de branche qui se jouxtent dans le plan complexe sont déphasés de $\pi/2$. Elle correspond aux huit autres valeurs des 16 valeurs ($2^4 = p^n$) possibles du signal de commande SCj.

En théorie, avec cette deuxième constellation, A'/A = 1,082.

Dès lors, bien que le circuit délivre en fait seize états du signal de sortie, ces seize états ne correspondent qu'à huit états de phase (et deux états d'amplitude dans un rapport de 7,66 dB).

Le circuit de la figure 2 peut être utilisé pour la transmission de signaux numériques par un signal porteur (signal d'entrée Se) hyperfréquence (fréquence comprise entre 1 GHz et 300 GHz) modulé en phase selon un codage MCT. Dans ce cas, on n'utilise de préférence que la première constellation d'amplitude maximale de façon à minimiser les pertes du modulateur. Il est à noter à cet égard que les transistors T0, T1, T2, T3 des cellules C0, C1, C2, C3 de déphasage des branches B0, B1, B2, B3 dérivées sont polarisés et réduisent les pertes, voire même apportent un gain, entre l'entrée 1 et la sortie 2.

Pour sélectionner la première constellation, il suffit de prévoir un circuit transcodeur entre le signal numérique codé sur 3 bits (8 états) et le signal SCj codé sur 4 bits dont seuls 8 combinaisons sont appliquées aux modulateurs Mi.

Le circuit de la figure 2 peut être réalisé en technologie MMIC et présente, pour une fréquence de 8 GHz, des dimensions de l'ordre de 4,3mm x 4,1mm en fournissant huit véritables états de phase, voire même seize états de phase si on choisit $\Delta\phi \neq \pi/4$ (par exemple avec $\Delta\phi = \pi/8$.

La figure 6 représente un exemple de constellation pouvant être obtenue avec le circuit de la figure 2 avec $\omega e/2\pi = 8$ GHz. Sur ce diagramme, chaque point représente l'extrémité du vecteur représentant le signal de sortie Ss, son amplitude (en dB) et sa phase (en degrés) étant indiquées.

La figure 7 illustre un deuxième mode de réalisation où le circuit selon l'invention est un BPSK à deux états de phase comprenant deux cellule C0, C1 de déphasage définissant deux branches dérivées B0, B1, de sorte que m = n = 2.

Dans le mode de réalisation, il est prévu des condensateurs auxiliaires 8, 9 reliés entre chaque noeud N0, NI de dérivation et la masse. La ligne de distribution 6 comprend des inductances série L/2, un condensateur d'entrée 16, un condensateur de terminaison 28, les résistances 13, 14 et le transistor 15 monté en résistance variable pour former le dispositif de terminaison 7, deux transistors T0, T1 à effet de champ avec leur inductance 10 et leur condensateur 11 de polarisation.

Dans ce mode de réalisation, l'étage 4 de commutation/modulation comprend deux circuits commutateurs CO0 et CO1 comprenant chacun deux transistors à effet de champ non polarisés 29, 30, 31, 32, dont le premier 29, 31 est monté en parallèle avec sa source reliée à la masse via une résistance série et son drain relié à la branche B0, B1, et le deuxième 30, 32 monté en série avec la source reliée au drain du premier transistor 29, 31 et dont le drain fournit le signal Ss0, Ss1 de sortie de branche. Les grilles des transistors 29, 30, 31, 32 reçoivent des tensions U, $\overline{U}$ à deux états formées à partir du signal de commande SCj qui peut lui-même prendre deux états U, $\overline{U}$ complémentaires, de façon que lorsque SCj = = SC1 = U, le signal Ss0 sur la première branche est non nul et égal au signal issu de la cellule de déphasage C0, alors que le signal Ss1 sur la deuxième branche est nul (les transistors 30 et 31 étant passants alors que les transistors 29 et 32 sont bloqués). Réciproquement, lorsque SCj = SC2 = $\overline{U}$, les transistors 30, 31 sont bloqués alors que les transistors 29, 32 sont passants, de sorte que le signal Ss0 est nul et que le signal Ss1 est le signal issu de la cellule de déphasage C1.

Lesdits moyens 5 pour sommer en phase les signaux de sortie de branche Ss0, Ss1 sont simplement formés de deux lignes 33, 34 qui sont de la même longueur et sont branchées en étoile à partir des deux sorties des circuits commutateurs Co0 et Co1 formés par les transistors 29, 30, 31, 32. Les deux lignes 33, 34 se rejoignent en un noeud de sortie formant la sortie 2 du circuit qui reçoit donc alternativement, soit le signal Ss0, soit le signal Ss1, selon l'état du signal de commande SCj.

Les inductances L, la capacité des condensateurs 8,9, les transistors T0, T1 des cellules C0, C1 de déphasage et la tension d'ajustement VA peuvent être choisis pour que Ss1 soit déphasé d'une valeur quelconque, même différente de 180° par rapport à Ss0. On obtient donc un BPSK à déphasage de valeur quelconque.

Par exemple, le déphasage peut être choisi à une valeur différente de 180° pour obtenir un modulateur bi-phase à porteuse résiduelle pour liaisons lointaines à très bas débits pour les sondes planétaires.

L'invention est particulièrement avantageuse pour la réalisation des circuits hyperfréquences (MMIC). Elle est néanmoins aussi applicable dans les autres domaines de fréquence pour la modulation par déplacement de phase.

En outre, l'invention est aussi applicable à la réalisation de circuits m-PSK à structure distribuée différents de ceux représentés et décrits ci-dessus, notamment avec d'autres valeurs de m, n et p.

Par ailleurs, il est à noter que les composants et fonctions électroniques de détail des circuits qui n'ont pas d'importance dans le cadre de la présente invention, et qui pourront aisément être choisis et déterminés par l'homme du métier, ne sont pas tous représentés ni décrits, de sorte que les circuits décrits et représentés ne doivent bien sûr pas être considérés comme totalement exhaustifs en ce qui concerne la constitution des puces obtenues en pratique.

## Revendications

**1.** Circuit électronique modulateur par déplacement de phase comprenant une entrée (1) destinée à recevoir un signal d'entrée sinusoïdal Se de pulsation $\omega e$ et une sortie (2) délivrant un signal de sortie sinusoïdal Ss déphasé du signal d'entrée d'une valeur $\phi j$ qui peut varier parmi m valeurs, $\phi 1$, ..., $\phi j$, ..., $\phi m$, m étant un entier supérieur ou égal à 2, en fonction d'un signal de commande SCj, le signal de sortie Ss ayant une pulsation $\omega s$ indépendante du signal de commande SCj, caractérisé en ce qu'il comprend :

- une ligne de distribution (6) s'étendant à partir de l'entrée et comprenant n cellules Co, ..., Ci, ..., Cn-1, de déphasage semblables, n étant un nombre entier supérieur ou égal à 2, les n cellules de déphasage étant montées le long de la ligne de distribution (6) avec chaque cellule Ci de déphasage de rang i le long de la ligne de distribution (6) comprenant :

    . une entrée, dite entrée série ISi, recevant le signal provenant de l'entrée du circuit, soit directement pour i = 0, soit par l'intermédiaire des (i-1) cellules de déphasage précédentes de rang inférieur à i, interposées entre l'entrée (1) du circuit et cette cellule Ci de déphasage,
    . une première sortie, dite sortie série OSi, délivrant le signal sur la ligne de distribution à une cellule Ci+1 de déphasage subséquente de rang i+1 supérieur, ou, pour i = n-1, à un dispositif de terminaison (7) de la ligne de distribution (6),
    . un noeud Ni de dérivation de la ligne de distribution (6),
    . une deuxième sortie, dite sortie dérivée ODi, reliée au noeud Ni de dérivation par l'intermédiaire d'un transistor Ti dont une première borne est reliée au noeud Ni de dérivation, dont une deuxième borne est reliée à la masse, et dont la troisième borne fournit ladite sortie dérivée ODi de la cellule Ci de déphasage, chaque cellule Ci de déphasage étant adaptée pour délivrer sur sa sortie dérivée ODi un signal SDi déphasé, par rapport au signal d'entrée Se, de la somme $\phi(Ci)$ des déphasages apportés au signal d'entrée Se successivement, depuis l'entrée (1) du circuit, par les cellules de déphasage interposées entre l'entrée (1) du circuit et ladite sortie dérivée ODi,

- relié à ladite sortie dérivée ODi de chaque cellule Ci de déphasage, un circuit commutateur/modulateur commandé à partir du signal de commande SCj, ce circuit commutateur/modulateur étant :

    . lorsque n = m, un circuit commutateur (CO0, CO1) délivrant soit un signal nul, soit le signal SDi reçu de la cellule Ci, en fonction du signal de commande SCj,
    . lorsque n ≠ m, un circuit modulateur Mo, ..., Mi, ..., Mn-1 de phase à p états, p étant un nombre entier inférieur à m choisi de façon que $m \leq p^n$, adapté pour déphaser le signal SDi reçu de la cellule Ci de déphasage d'une valeur $\phi k$, k étant un nombre entier variant entre 1 et p, en fonction du signal de commande SCj,

    - des moyens (5) pour sommer en phase les signaux Ssi issus des n circuits commutateurs/modulateurs, et pour délivrer sur ladite sortie (2) du circuit le résultat de cette somme qui forme le signal de sortie Ss.

2. Circuit selon la revendication 1, caractérisé en ce que chaque transistor Ti des cellules de déphasage est un transistor à effet de champ, et en ce qu'il comporte des moyens (10, 11) de polarisation des transistors à effet de champ des cellules de déphasage.

3. Circuit selon l'une des revendications 1 et 2, caractérisé en ce que chaque transistor Ti des cellules de déphasage est un transistor à effet de champ dont :

    - la première borne est la grille,
    - la deuxième borne est la source,
    - la troisième borne est le drain,

et en ce qu'il comprend des moyens (12) pour appliquer une tension continue de valeur ajustable à chaque noeud Ni de dérivation, de façon à former une capacité ajustable entre le noeud Ni de dérivation et la masse.

4. Circuit selon l'une des revendications 1 à 3, caractérisé en ce que toutes les cellules de déphasage sont fonctionnellement identiques et créent un même déphasage $\Delta\phi$ le long de la ligne de distribution (6), la cellule Ci délivrant sur sa sortie dérivée un signal dérivé SDi déphasé par rapport au signal d'entrée Se de $\phi(Ci) = i \times \Delta\phi + \psi$, où $\psi$ est une constante.

5. Circuit selon la revendication 4, caractérisé en ce que $\Delta\phi = 2\pi/m$.

6. Circuit selon l'une des revendications 1 à 5, caractérisé en ce que lesdits moyens (5) pour sommer en phase comprennent des lignes (33, 34) de branchement en étoile, qui sont toutes de la même longueur, des sorties des n circuits commutateurs/modulateurs en un noeud de sortie commun.

7. Circuit selon l'une des revendications 1 à 6, caractérisé en ce que lesdits moyens (5) pour sommer en phase comprennent un circuit combineur en phase formé d'une arborescence de coupleurs (25, 26, 27) de Wilkinson dont le dernier sommet forme ladite sortie (2) du circuit.

8. Circuit selon l'une des revendications 1 à 7, caractérisé en ce que lorsque m est un multiple d'une puissance de 2, n est égal à une puissance de 2.

**9.** Circuit selon l'une des revendications 1 à 8, caractérisé en ce que :

- m est supérieur ou égal à 4,
- p est égal à 1, 2 ou 4.

**10.** Circuit selon l'une des revendications 1 à 9, caractérisé en ce que :

- m est supérieur ou égal à 8,
- n est supérieur ou égal à 4.

**11.** Circuit selon l'une des revendications 1 à 10, caractérisé en ce que les circuits commutateurs/modulateurs sont semblables et comprennent uniquement des composants passifs.

**12.** Circuit selon l'une des revendications 1 à 11, caractérisé en ce que p = 2 et en ce que les circuits commutateurs/modulateurs sont des circuits BPSK de modulation de phase à deux états de phase à composants passifs formés chacun d'un filtre passe-haut (18) et d'un filtre passe-bas (17) montés en parallèle et dont les sorties sont commutées par un montage à transistors (21, 22) à effet de champ non polarisés avec leur grille recevant un signal de commande à deux états complémentaires.

**13.** Circuit selon l'une des revendications 1 à 12, caractérisé en ce que chaque cellule Ci de déphasage est du type à inductance série et capacité parallèle, en ce que ledit transistor Ti de chaque cellule Ci de déphasage est un transistor à effet de champ polarisé, dont la grille est reliée au noeud de dérivation Ni sur la ligne de distribution (6) en parallèle à l'inductance , dont la source est reliée à la masse, et dont le drain fournit le signal dérivé SDi à ladite sortie dérivée ODi, et en ce que ladite capacité parallèle est au moins pour partie constituée de la capacité formée entre la grille et la source dudit transistor Ti à effet de champ polarisé.

**14.** Circuit selon les revendications 3 et 13, caractérisé en ce que les moyens (12) pour appliquer et ajuster une tension continue de valeur ajustable à chaque noeud Ni de dérivation comportent une borne (12) de la ligne de distribution (6) adaptée pour pouvoir recevoir une tension continue VA, de sorte que les déphasages du signal à chaque noeud Ni de dérivation des cellules Ci de déphasage peuvent être ajustés simultanément, notamment en fonction de la pulsation ωe, par réglage de cette seule tension continue variable VA.

**15.** Circuit selon la revendication 14, caractérisé en ce qu'il comporte des moyens (13, 14, 15) formant une impédance variable à une borne d'extrémité de la ligne de distribution (6) opposée à l'entrée (4) du circuit, pour permettre son adaptation d'impédance.

**16.** Circuit selon la revendication 15, caractérisé en ce que l'impédance variable comprend un transistor (15) à effet de champ monté en résistance variable, et dont la grille reçoit une tension continue de réglage VR.

**17.** Circuit selon l'une des revendications 1 à 16, caractérisé en ce que la fréquence du signal d'entrée étant supérieure à 1 Gigahertz, il est formé d'un circuit intégré monolithique.

**Patentansprüche**

**1.** Elektronische Phasenumtastungs-Modulatorschaltung, umfassend einen Eingang (1) zum Empfangen eines sinusförmigen Eingangssignals Se mit Impuls ωe und einen Ausgang (2) zum Anlegen eines sinusförmigen Ausgangssignals Ss, das vom Eingangssignal um einen Wert φj phasenverschoben ist, der zwischen m Werten φ1 ..., φj, ..., φm, wobei m eine ganze Zahl größer oder gleich 2.ist, in Abhängigkeit von einem Befehlssignal SCj variieren kann, wobei das Ausgangssignal Ss ein Impuls ωs unabhängig vom Befehlssignal SCj ist, dadurch gekennzeichnet, dass sie folgendes umfasst:

- eine Verteilungsleitung (6), die sich vom Eingang erstreckt und n Zellen Co, ..., Ci, ..., Cn-1 mit gleicher Phasenverschiebung umfasst, wobei n eine ganze Zahl größer oder gleich 2 ist, wobei die n Phasenverschiebungszellen entlang der Verteilungsleitung (6) montiert sind, wobei jede Phasenverschiebungszelle Ci vom Rang i entlang der Verteilungsleitung (6) folgendes umfasst:

  • einen Eingang, als Serieneingang ISi bezeichnet, der das Signal vom Eingang der Schaltung empfängt, entweder direkt für i = 0 oder über vorhergehende (i-1) Phasenverschiebungszellen mit einem Rang kleiner i, die zwischen dem Eingang (1) der Schaltung und dieser Phasenverschiebungszelle Ci positioniert sind,

  • einen ersten Ausgang, als Serienausgang OSi bezeichnet, der das Signal über die Verteilungsleitung zu einer nachfolgenden Phasenverschiebungszelle Ci+1 mit höherem Rang i+1 oder, für i = n-1, zu einem Endgerät (7) der Verteilungsleitung (6) überträgt,

  • einen Abzweigknoten Ni der Verteilungsleitung (6),

- einen zweiten Ausgang, als Abzweigausgang ODi bezeichnet, der mit dem Abzweigknoten Ni über einen Transistor Ti verbunden ist, dessen erster Anschluss mit dem Abzweigknoten Ni verbunden ist, dessen zweiter Anschluss mit Masse verbunden ist und dessen dritter Anschluss den genannten Abzweigausgang ODi der Phasenverschiebungszelle Ci bereitstellt, wobei jede Phasenverschiebungszelle Ci die Aufgabe hat, an ihren Abzweigausgang ODi ein Signal SDi anzulegen, das in Bezug auf das Eingangssignal Se von der Summe $\phi$(Ci) der nacheinander auf das Eingangssignal Se angewendeten Phasenverschiebungen seit dem Eingang (1) der Schaltung durch die Phasenverschiebungszellen zwischen dem Eingang (1) der Schaltung und dem genannten Abzweigausgang Odi phasenverschoben ist,

- verbunden mit dem genannten Abzweigausgang ODi jeder Phasenverschiebungszelle Ci eine Kommutator/Modulator-Schaltung, die durch das Befehlssignal SCj gesteuert wird, wobei die genannte Kommutator/Modulator-Schaltung:

  - wenn n = m, eine Kommutatorschaltung (CO0, CO1) ist, die entweder ein Nullsignal oder das von der Zelle Ci empfangene Signal SDi in Abhängigkeit vom Steuersignal SCj anlegt,

  - wenn n ≠ m, eine Phasenmodulatorschaltung Mo, ..., Mi, ..., Mn-1 mit p Zuständen ist, wobei p eine ganze Zahl kleiner m ist, die so gewählt wird, dass m≤ $p^n$, um das von der Phasenverschiebungszelle Ci empfangene Signal SDi um einen Wert $\phi_k$ zu verschieben, wobei k eine ganze Zahl ist, die in Abhängigkeit vom Steuersignal SCj zwischen 1 und p variiert,

- Mittel (5) für eine Phasensummierung der Signale SSi, die von den n Kommutator/Modulator-Schaltungen ausgegeben werden, und zum Anlegen des Ergebnisses dieser Summierung, die das Ausgangssignal Ss bildet, an den genannten Ausgang (2) der Schaltung.

2. Schaltung nach Anspruch 1, dadurch gekennzeichnet, dass jeder Transistor Ti der Phasenverschiebungszellen ein Feldeffekttransistor ist, und dadurch, dass sie Polarisationsmittel (10, 11) der Feldeffekttransistoren der Phasenverschiebungszellen umfasst.

3. Schaltung nach einem der Ansprüche 1 und 2, dadurch gekennzeichnet, dass jeder Transistor Ti der Phasenverschiebungszellen ein Feldeffekttransistor ist, dessen:

  - erster Anschluss das Gitter ist,
  - zweiter Anschluss die Source ist,
  - dritter Anschluss der Drain ist,

  und dadurch, dass sie ein Mittel (12) zum Anlegen einer Gleichspannung mit einem einstellbaren Wert an jeden Abzweigknoten Ni umfasst, um eine einstellbare Kapazität zwischen dem Abzweigknoten Ni und Masse zu erzielen.

4. Schaltung nach einem der Ansprüche 1 bis 3, dadurch gekennzeichnet, dass alle Phasenverschiebungszellen funktionell identisch miteinander sind und dieselbe Phasenverschiebung $\Delta\phi$ entlang der Verteilungsleitung (6) erzeugen, wobei die Zelle Ci an ihren Abzweigausgang ein Abzweigsignal SDi anlegt, das in Bezug auf das Eingangssignal Se von $\phi$(Ci) = $ix\Delta\phi + \psi$ phasenverschoben ist, wobei $\psi$ eine Konstante ist.

5. Schaltung nach Anspruch 4, dadurch gekennzeichnet, dass $\Delta\phi = 2\pi/m$ ist.

6. Schaltung nach einem der Ansprüche 1 bis 5, dadurch gekennzeichnet, dass das genannte Mittel (5) zum Phasensummieren sternförmige Abzweigungsleitungen (33, 34), alle mit derselben Länge, von den Ausgängen der n Kommutator/Modulator-Schaltungen zu einem gemeinsamem Ausgangsknoten umfasst.

7. Schaltung nach einem.der Ansprüche 1 bis 6, dadurch gekennzeichnet, dass das genannte Mittel (5) zum Phasensummieren eine Phasenkombinationsschaltung umfasst, die von einer baumförmigen Wilkinson-Kupplungsschaltung (25, 26, 27) gebildet wird, deren letzter Scheitelpunkt den genannten Ausgang (2) der Schaltung bildet.

8. Schaltung nach einem der Ansprüche 1 bis 7, dadurch gekennzeichnet, dass, wenn m ein Vielfaches einer Zweierpotenz ist, n gleich einer Zweierpotenz ist.

9. Schaltung nach einem der Ansprüche 1 bis 8, dadurch gekennzeichnet, dass:

  - m größer oder gleich 4 ist,
  - p gleich 1, 2 oder 4 ist.

10. Schaltung nach einem der Ansprüche 1 bis 9, dadurch gekennzeichnet, dass:

- m größer oder gleich 8 ist,
- n größer oder gleich 4 ist.

**11.** Schaltung nach einem der Ansprüche 1 bis 10, dadurch gekennzeichnet, dass die Kommutator/Modulator-Schaltungen ähnlich sind und nur passive Komponenten aufweisen.

**12.** Schaltung nach einem der Ansprüche 1 bis 11, dadurch gekennzeichnet, dass p = 2 ist und dadurch, dass die Kommutator/Modulator-Schaltungen BPSK-Phasenmodulationsschaltungen mit zwei Phasenzuständen mit passiven Komponenten sind, jeweils mit einem Hochpassfilter (18) und einem Tiefpassfilter (17), die parallel geschaltet und deren Ausgänge durch die Montage von unpolarisierten Feldeffekttransistoren (21, 22) kommutiert werden, wobei ihr Gitter ein Steuersignal mit zwei komplementären Zuständen empfängt.

**13.** Schaltung nach einem der Ansprüche 1 bis 12, dadurch gekennzeichnet, dass jede Phasenverschiebungszelle Ci vom Typ mit Serieninduktanz und paralleler Kapazität ist, dadurch, dass der genannte Transistor Ti jeder Phasenverschiebungszelle Ci ein polarisierter Feldeffekttransistor ist, dessen Gitter mit dem Abzweigknoten Ni auf der Verteilungsleitung (6) parallel zur Induktanz geschaltet ist, dessen Source mit Masse verbunden ist und dessen Drain das Abzweigsignal SDi an den genannten Abzweigausgäng ODi anlegt, und dadurch, dass die genannte parallele Kapazität wenigstens teilweise aus der Kapazität besteht, die zwischen dem Gitter und der Source des genannten polarisierten Feldeffekttransistors Ti gebildet wird.

**14.** Schaltung nach den Ansprüchen 3 und 13, dadurch gekennzeichnet, dass das Mittel (12) zum Anlegen und Einstellen einer Gleichspannung mit einstellbarem Wert an jedem Abzweigknoten Ni einen Anschluss (12) der Verteilungsleitung (6) aufweist, die eine Gleichspannung VA empfangen kann, so dass die Phasenverschiebungen des Signals an jedem Abzweigkhoten Ni der Phasenverschiebungszellen Ci gleichzeitig eingestellt werden können, insbesondere in Abhängigkeit vom Impuls ωe, durch Regelung nur dieser variablen Gleichspannung VA.

**15.** Schaltung nach Anspruch 14, dadurch gekennzeichnet, dass die Mittel (13, 14, 15) zur Bildung einer veränderlichen Impedanz am Außenanschluss der Verteilungsleitung (6) gegenüber dem Eingang (4) der Schaltung bildet, um die Adaption ihrer Impedanz zuzulassen.

**16.** Schaltung nach Anspruch 15, dadurch gekennzeichnet, däss die veränderliche Impedanz einen Feldeffekttransistor (15) mit veränderlichem Widerstand umfasst, dessen Gitter eine Regelgleichspannung VR empfängt.

**17.** Schaltung nach einem der Ansprüche 1 bis 16, dadurch gekennzeichnet, dass die Schaltung, da die Frequenz des Eingangssignals größer als 1 Gigahertz ist, durch eine monolithische integrierte Schaltung gebildet wird.

**Claims**

**1.** An electronic phase-shift keying modulator circuit comprising an input (1) intended to receive a sinusoidal input signal Se of angular frequency ωe and an output (2) delivering a sinusoidal output signal Ss phase shifted with respect to the input signal by a value $\phi j$ which can vary among m values, $\phi 1$, ..., $\phi j$, ..., $\phi m$, m being an integer greater than or equal to 2, in accordance with a control signal SCj, the output signal Ss having an angular frequency ωs that is independent of the control signal Scj, wherein said circuit comprises:

- a distribution line (6) extending from the input and including n cells Co, ..., Ci, ..., Cn-1, of similar phase shift, n being a whole number greater than or equal to 2, the n phase-shift cells being mounted along the distribution line (6) with each phase-shift cell Ci of rank i along the distribution line (6) comprising:

  . an input, referred to as the series input ISi, receiving the signal coming from the input of the circuit, either directly where i = 0, or via (i-1) preceding phase-shift cells of rank less than i, interposed between the input (1) of the circuit and this phase-shift cell Ci,
  . a first output, referred to as the series output OSi, delivering the signal on the distribution line to a subsequent phase-shift cell Ci+1 of higher rank i+1, or, where i = n-1, to a terminating device (7) of the distribution line (6),
  . a tapping point Ni of the distribution line (6),
  . a second output, referred to as the branched output ODi, connected to the tapping point Ni via a transistor Ti whose first terminal is connected to the tapping point Ni, whose second terminal is connected to ground, and whose third terminal supplies said branched output ODi of the phase-shift cell Ci, each phase-shift cell Ci being designed to deliver at its branched output ODi a signal SDi that is phase shifted with respect to the input signal Se, by the sum $\phi(Ci)$. of the phase shifts successively applied to the input signal Se, from the input (1) of the circuit by the phase-shift cells interposed between the input (1) of the circuit and said branched output ODi,

- connected to said branched output ODi of each phase-shift cell Ci, a switching/modulating circuit controlled by the control signal SCj, this switching/modulating circuit being:

  . when n = m, a switching circuit (CO0, CO1) delivering either a zero signal, or the signal SDi received from the cell Ci, in accordance with the control signal SCj,

  . when n ≠ m, a modulating circuit Mo, ..., Mi, ..., Mn-1 with p phase states,. p being a whole number less than m chosen so that $m \leq p^n$, designed to phase-shift the signal SDi received from the phase-shift cell Ci by a value $\phi k$, k being a whole number varying between 1 and p, in accordance with the control signal SCj,

- means (5) for summing in phase the signals Ssi coming from n switching/modulating circuits and to deliver at said output (2) of the circuit the result of this sum which forms the output signal Ss.

2. The circuit as claimed in claim 1, wherein each transistor Ti of the phase-shift cells is a field-effect transistor, and wherein said circuit comprises means (10, 11) for biasing the field-effect transistors of the phase-shift cells.

3. The circuit as claimed in one of the claims 1 and 2, wherein each transistor Ti of the phase-shift cells is a field-effect transistor whose:

- first terminal is the gate,
- second terminal is the source,.
- third terminal is the drain,

and wherein said circuit comprises means (12) for applying a DC voltage whose value is adjustable at the tapping point Ni, so as to form an adjustable capacitance between the tapping point Ni and ground.

4. The circuit as claimed in one the claims 1 to 3, wherein all the phase-shift cells are functionally identical and generate the same phase shift $\Delta\phi$ along the distribution line (6), the cell Ci delivering at its branched output a branched signal SDi that is phase-shifted with respect to the input signal Se by $\phi(Ci) = ix\Delta\phi + \psi$, where $\psi$ is a constant.

5. The circuit as claimed in claim 4, wherein $\Delta\varnothing = 2\pi/m$.

6. The circuit as claimed in one of the claims 1 to 5, wherein said means (5) for summing in phase comprise star-connection lines (33, 34), all of which have the same length, from the outputs of n switching/modulating circuits at a common output point.

7. The circuit as claimed in one of the claims 1 to 6, wherein said means (5) for summing in phase comprise a phase combiner circuit formed by a Wilkinson coupler tree (25, 26, 27) the final apex of which forms said output (2) of the circuit.

8. The circuit as claimed in one of the claims 1 to 7, wherein when m is a multiple of a power of 2, n is equal to a power of 2.

9. The circuit as claimed in one of the claims 1 to 8, wherein

- m is greater than or equal to 4,
- p is equal to 1, 2 or 4.

10. The circuit as claimed in one of the claims 1 to 9, where in

- m is greater than or equal to 8,
- n is greater than or equal to 4.

11. The circuit as claimed in one of the claims 1 to 10, wherein the switching/modulating circuits are similar and consist exclusively of passive components.

12. The circuit as claimed in one of the claims 1 to 11, wherein p = 2 and wherein the switching/modulation circuits are binary phase-shift keying BPSK modulator circuits with passive components, each formed by a high-pass filter (18) and a low-pass filter (17) connected in parallel and whose outputs are switched by a non-biased field-effect transistor array (21, 22) with their gate receiving a control signal having two complementary states.

13. The circuit as claimed in one of the claims 1 to 12, wherein each phase-shift cell Ci is of a series inductance and parallel capacitance type, wherein said transistor Ti of each phase-shift cell Ci is a biased field-effect transistor whose gate is connected to the tapping point Ni on the distribution line (6) in parallel with the inductance, whose source is connected to ground, and whose drain supplies the branched signal SDi to said branched output ODi, and wherein said parallel capacitance is at least partially made up of the capacitance formed between the gate and the source of said biased field-effect transistor Ti.

14. The circuit as claimed in claims 3 and 13, wherein the means (12) for applying and adjusting a DC voltage of an adjustable value to each tapping point Ni include a terminal (12) of the distribution line (6) intended to receive a DC voltage VA so that the phase shifts of the signal at each tapping point Ni of the phase-shift cells Ci can be adjusted simultaneously, in particular in accordance with the angular frequency $\omega_e$, by setting this one variable DC voltage VA.

15. The circuit as claimed in claim 14, wherein it comprises means (13, 14, 15) forming a variable impedance at one end terminal of the distribution line (6) opposite to the input (4) of the circuit, to allow its impedance matching.

16. The circuit as claimed in claim 15, wherein the variable impedance comprises a field-effect transistor (15) configured as a variable resistance, and whose gate receives. a DC control voltage VR.

17. The circuit as claimed in one of the claims 1 to 16, wherein the frequency of the input signal is greater than 1 Gigahertz and said circuit is formed from a monolithic integrated circuit.

Fig 1

Fig 2

Fig 3

EP 0 963 623 B1

Fig 4

Fig 5

Fig 6

Fig 7